Europäisches Patentamt

European Patent Office

Office européen des brevets

(19)

(11) Publication number: **0 387 001**

**A2**

(12) **EUROPEAN PATENT APPLICATION**

(21) Application number: **90302375.2**

(22) Date of filing: **06.03.90**

(51) Int. Cl.5: **H05K 3/26, B08B 3/02**

(30) Priority: **06.03.89 US 319505**
**22.12.89 US 456108**

(43) Date of publication of application:
**12.09.90 Bulletin 90/37**

(84) Designated Contracting States:
**BE DE FR GB IT NL**

(71) Applicant: **ELECTROVERT LIMITED**
**44 Dufflaw Road**
**Toronto Ontario M6A 2W1(CA)**

(72) Inventor: **Mittag, Michael T.**
**8 Noth Street, P.O. Box 31**
**New Haven, Vermont 05472(US)**
Inventor: **Elliot, Donald A.**
**7455 Trinidad, Brossard**
**Quebec, J4W 1N3(CA)**
Inventor: **Roberts, Alan S.**
**41 Cedar Avenue, Pointe Claire**
**Quebec, H9S 4Y3(CA)**

(74) Representative: **Warren, Keith Stanley et al**
**BARON & WARREN 18 South End Kensington**
**London W8 5BU(GB)**

(54) **Method and apparatus for cleaning electronic and other devices.**

(57) A method and apparatus for cleaning workpieces (16), particularly printed circuit boards upon which electrical components have been soldered, is capable of using a potentially flammable or explosive liquid cleaning solvent. In one embodiment, there are two immersion wash stages between which is a spray wash stage. The spray wash stage is formed as a closed chamber (28) which is sealed from the immersion wash stages by liquid seals (18,30). To reduce the danger of fire or explosion in the spray wash stage an inert gas such as Nitrogen is introduced into the closed chamber (28). In another embodiment the spray nozzles (3) are immersed in liquid solvent in a combined immersion/spray wash stage. This reduces atomization of the flammable solvent further reducing the danger of fire or explosion.

FIG. I

## METHOD AND APPARATUS FOR CLEANING ELECTRONIC AND OTHER DEVICES

This invention relates to the cleaning of workpieces, particularly but not exclusively to the cleaning of printed circuit boards upon which electrical components have been soldered.

When such circuit boards emerge from the soldering process they have thereon contaminants such as flux residues and the like which have to be removed by using a liquid cleaning solvent. One of the solvents used widely for such a task, namely stabilized aseotrope of CFC-113 and methanol available commercially as Dupont Freon TNS, is totally safe from fire or explosive hazard. However, this solvent is known to deplete the ozone layer and will most probably become banned throughout the world by a large number of countries who signed the UNEP agreement in 1987.

New solvents or cleaning agents are being tried, not as direct substitutes, but as alternatives. Some of these alternative solvents are Terpene based such as Petroferm EC-7, Envirosolv Re-Entry and other Terpene and/or alcohol based solvents which unfortunately have a low flash point and when sprayed as a cleaning agent for metal parts, electronics circuits and the like in air, the risk of a potential fire or explosion becomes very real.

Previously, solvents which are safe have been located in open top tank type cleaning machines, some of which may have had cooling coils to contain the solvent vapours within the open top tank. Other machines were made longer, some with multiple stages and a conveyor system consisting of either baskets on a transporting device or with a conveyor belt which would convey parts down into the open top tank into the vapour zone, sometimes also into the liquid cleaning solvent and which also may have been boiling and in some cases may also have had an improved mechanical cleaning effect with ultrasonic agitation of the solvent and/or with mechanical pumping devices and nozzles to spray on the workpiece which result in improved cleaning. The tops of these machines are sometimes closed to reduce solvent losses with entrance and exit openings for the workpieces.

With the recent advent of electronic circuits such as those containing surface mounted devices (SMD) and the like which are mounted quite flush to the circuit board and which are known to present cleaning difficulties, equipment has been developed with high pressure sprays up to the order of 200 psi (12 atmospheres) pressure and even higher. In order to contain the spray and resulting increased losses of the solvent associated with such high pressures, systems exist for transporting metal parts and the like in a basket transport system through liquid seals; see for example United States Patent 3,120,853. More recently, vapour degreasing of workpieces through similar machines without transporting baskets but with an endless mesh belt transport conveyor with liquid seals for containment of the high pressure spray, whereby the high pressure spray and associated vapours are contained in a central zone and the entrance and exit zones are generally quiet, thereby resulting in high containment of the solvent in the machine.

Such a machine is the Electrovert SC-500 solvent cleaner which is described in Electrovert Bulletin No. 164-80. This machine comprises means for conveying the workpieces in turn through a first immersion wash stage, a spray wash stage and a second immersion wash stage, each immersion wash stage comprising a tank for holding liquid cleaning solvent, the spray wash stage being formed as an enclosed chamber sealed from the two immersion wash stages and having therein spray nozzles for directing sprays of liquid cleaning solvent onto the workpieces.

The use of potentially flammable or explosive solvents in such cleaning machines is hazardous. This is particularly true for the central zone where the spray nozzles are located because of the intimate mixing of the liquid droplets in the air contained in that zone.

It is an object of the present invention to provide a method and apparatus which reduces this inherent danger.

The invention solves the problem of ignition or explosion within the two spray wash stage or zone by adopting special measures especially within the spray wash stage.

According to one aspect, the invention involves injecting into the central zone an inert gas such as $N_2$ or steam to displace the air therefrom, thereby minimizing the potential for ignition or explosion.

According to another aspect, the spray nozzles are formed in a combined immersion and spray wash stage with the nozzles being located under the surface of the liquid cleaning solvent thereby reducing the atomization of the solvent.

In the accompanying drawings:

Figure 1 is a schematic diagram illustrating a first embodiment of the invention,

Figure 2 is a schematic diagram illustrating a modified portion of a second embodiment of the invention;

Figure 3 is a schematic diagram illustrating an alternative modification of the invention;

Figure 4 is a schematic diagram of a further embodiment of the invention; and

Figure 5 is a schematic diagram of yet another embodiment of the invention.

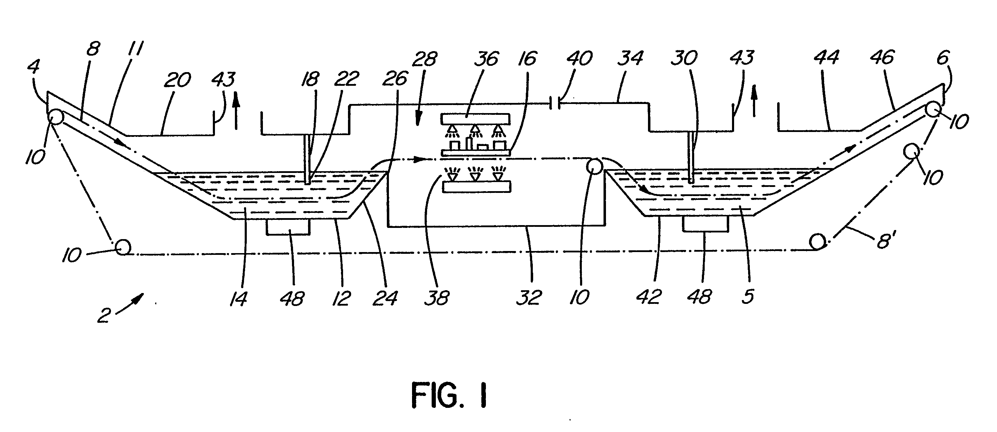

Referring firstly to Figure 1, it should be understood that the sides of the illustrated cleaning machine 2 lying in planes parallel to the plane of the drawing have been omitted to illustrate internal details. The cleaning machine 2 has an entrance 4 shown at the lefthand side of the figure and an exit 6 shown at the righthand side. An endless mesh belt transport conveyor 8 passes through various treatment zones in the machine from the entrance to the exit with the return loop 8' of the conveyor being located outside the treatment zones. The conveyor 8 is carried on rollers, some of which are illustrated at 10, which constrain the conveyor to a predetermined path and also provide the driving force for the conveyor.

Starting from the entrance 4, the conveyor 8 passes along and down a sloping channel 11 which opens out into a tank 12 which contains a quantity of liquid cleaning solvent 14 through which the conveyor 8 passes. Tank 12 thus defines an immersion wash stage for the workpieces 16 carried on the conveyor 8. The liquid cleaning solvent in the tank is at room temperature or at some other temperature which is below the flash point of the solvent. This immersion wash stage can be described as a relatively quiet zone in the sense that there is little physical disturbance of the body of liquid solvent. This is enhanced by virtue of a vertical wall 18 extending down from the roof 20 of the tank into the liquid solvent 14, the lower end 22 of the wall being below the surface of the liquid solvent 14 and thereby serving as a liquid seal.

The left-hand side of tank 12 is sloped to conform to the slope of channel 11 and the right-hand side 24 of tank 12 is inclined in the opposite direction, terminating in a lip 26 at its upper end, this defining the uppermost level of the liquid solvent 14. The conveyor 8 follows the contours of tank 12 into a central zone 28 defined between liquid seal 18 and another liquid seal 30, described below, and comprising additionally a tray or tank 32 and a top 34 extending between liquid seals 18 and 30.

The central zone 28 should be understood to form a closed chamber formed by tank 32, top 34, liquid seals 18 and 30 and portions of the sides (omitted from the drawing) of the machine.

At least one set of spray nozzles 36 is located above and below the conveyor in zone 28, the nozzles being directed towards the conveyor for providing a spray 38 of low to ultra-high pressure of the solvent onto the workpiece to clean residue from the workpiece. The pump (or pumps) for providing the necessary pressure and the plumbing are omitted from the drawing as these features are not per se germane to the present invention. Reference may be made to United States Patent 3,868,272, the disclosure of which is incorporated herein by reference, for further details of specific novel arrangements which may be utilized with the present invention.

The tank 32 in central zone 28 is shown dry but, in practice, there would be some liquid solvent in the tank which originated from the nozzles 36. A drain and or recirculating system could be provided for the liquid solvent which collects in tank 32.

A valved inlet 40 is provided in the top 34 of tank 32 for introducing an inert gas (or mixture of gases) such as $N_2$ or steam into the central zone 28. This inert gas is retained in zone 28 by the liquid seals 18 and 30 and fills the entire spray zone including spaces between the droplets forming the spray. The exclusion of oxygen from this zone greatly reduces the risk of fire or explosion. Preferably, the pumps (and any other potentially fire producing components) for producing the spray are located under top 34 within the inert gas environment.

The right-hand side of the machine 2 is a mirror image of the left-hand side, comprising a tank 42 similar to tank 12 containing liquid cleaning solvent into which the liquid seal 30 extends from tank top 44 and an exit channel 46 sloping up to exit 6. Again the path of the conveyor 8 conforms to the slope of the sides and bottom of tank 42. Tank 42 is an immersion rinse stage which is functionally identical to the immersion wash stage provided by tank 12 except the solvent used in tank 42 is pure to ensure that any remaining contaminants are removed from the workpiece. As with tank 12, tank 42 defines a relatively quiet zone separated from the central zone 28 by a liquid seal.

Although the greatest potential fire hazard is believed to be in the central zone 28 and this has been neutralized by the inert gas, potentially flammable vapours above tanks 12 and 42 may be extracted through ports 43 in the tank tops 20 and 44. Alternatively, instead of withdrawing vapours in the quiet zones, the same or different inert gas as is pumped into the central zone could be pumped into the quiet zones through inlets located, for example, where the ports 43 are located. In such a case the inert gas would be introduced above the free surface of the liquid in the tanks 12 and 42 but it is envisaged that the inert gas inlets could instead be provided in the bottom of the tanks, for example, so that the inert gas would be introduced below the free surface of the liquid. The resulting bubbling agitation might improve the cleaning efficiency of the immersion stages. As another alternative a blanket of a compatible liquid could be floated on top of the liquid solvent in the tanks 12 and 42. Such a compatible liquid preferably would be a freon based solvent less powerful and less dense than the potentially flammable solvent and immiscible therewith. Of course, in tank 12 the liquid blanket would be confined to the left of liquid seal 18 and, in tank 42, the liquid blanket would be confined to the right of liquid seal 30. The need for such safety precautions in the quiet zones would depend on the vapour pressure and other characteristic properties of the solvent used.

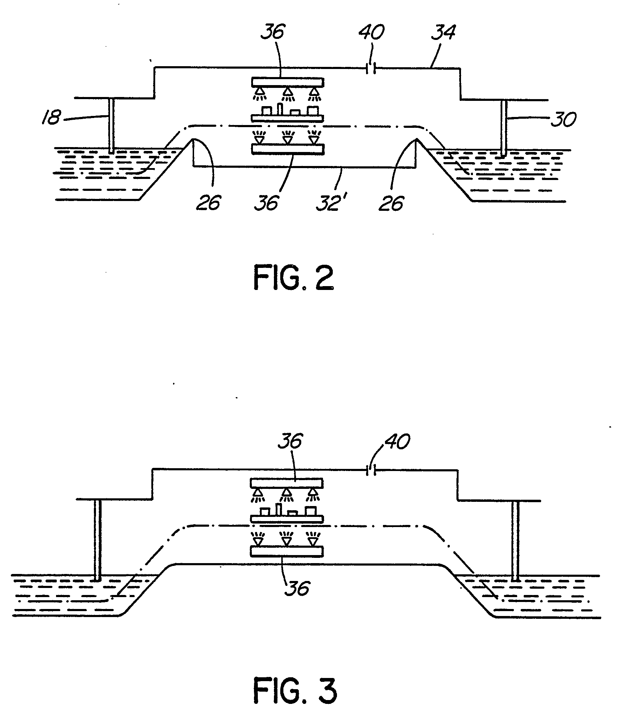

In order to reduce further the risk of ignition or explosion, the two sets of spray nozzles 36 could be replaced with a single set of nozzles above the conveyor, these nozzles being configured and dimensioned in relation to the pressure to flood rather than spray the components being cleaned. This would substantially reduce the amount of solvent atomized droplets, splashing, secondary spray, aerosols and vapour present in the central zone. This possible modification also applies to the embodiment of Figures 2, 3 and 4 described hereinbelow.

As a further safety feature the entrance 4 to the quiet zone 12 and the exit 6 from the quiet zone 42 could be in the form of a fluid barrier curtain system as described in United States Patent 4,696,226, the disclosure of which is incorporated herein by reference. Instead of the system described in that patent, the entrance 4 could consist of a double door arrangement to permit workpieces to enter via a first door which then closes before a second door opens to permit passage of the workpieces into the quiet zone 12. A similar double door arrangement would be provided at exit 6.

It is envisioned that each of the three zones could be monitored by detectors which detect and control the ratio of oxygen to other gases or liquids or at least set off an alarm indicating a hazardous mixture.

Other cleaning stages or components could be added to the machine of the instant invention without departing from the scope or spirit of the invention. For example, ultrasonic transducers 48 are shown in the bottom of each tank 12 and 42. Such ultrasonic components are commonly used in the art to provide improved cleaning in the two immersion stages.

Furthermore, although in the embodiment described above two immersion stages are used, it is envisaged that under some circumstances one immersion stage would suffice.

Referring now to Figure 2, this shows a modified central zone in which a shallow tray 32′ replaces the relatively deep tank 32. This reduces the volume of liquid in the central zone. The rest of the machine can be as illustrated in Figure 1. However, Figure 2 shows the liquid solvent in tanks 12 and 42 not quite coming up to the lips 26.

In the further modification of Figure 3 the central zone lacks entirely a tank or tray, the run off from the nozzles 36 going directly into the tanks 12 and 42. Thus, the volume of the central zone has been reduced further.

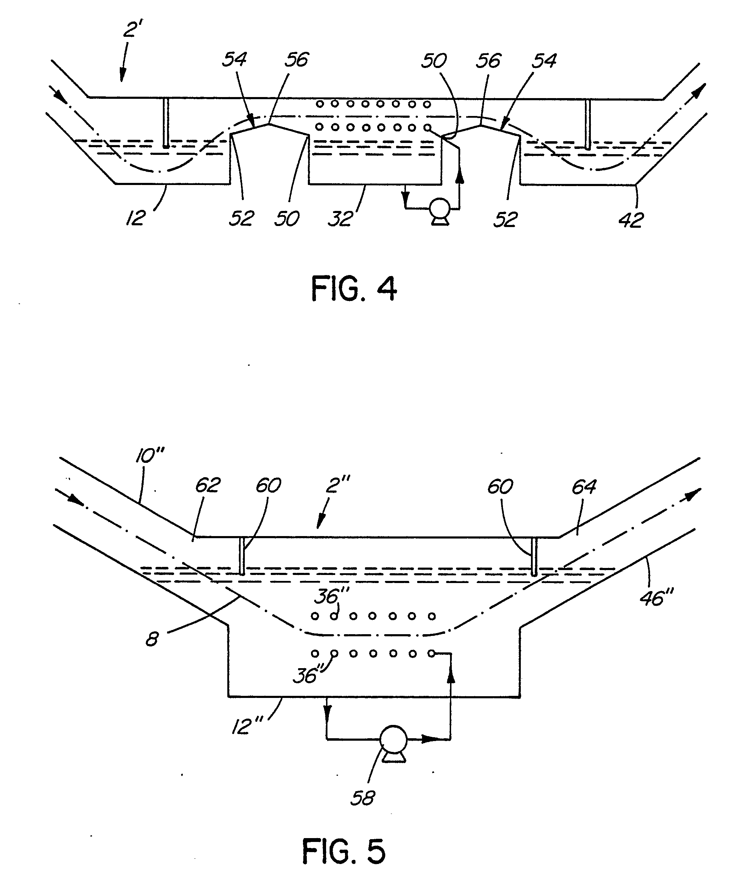

Referring now to Figure 4, the cleaning machine 2′ is virtually identical to the cleaning machine 2 of Figure 1 except that the tank 32 of the central zone is not contiguous with the tanks 12 and 42 of the two immersion stages. In fact, two upper edges or lips 50 of tank 32 are connected to upper edges 52 of tanks 12 and 42, respectively, by means of two inverted V shaped surfaces 54 forming a ridge 56 intermediate tank 32 and tank 12 or 42.

In contrast to the first machine 2, cleaning machine 2′ uses a conventional non-flammable (or low flammability) solvent in tank 12 of the first immersion stage and uses water in tank 42 of the second immersion stage. Only the spray stage uses the low flash point solvent. The V-shaped surfaces 44 allow run back of liquid to the proper tanks although there would be some carry-over of liquid from one tank to the next. This could be minimized by means of $N_2$ knives. It is noted that there would be no carry over of water to the tank 32 and so no foaming of the low flash point solvent would occur.

Make-up water for tank 42 could be provided by means of spray nozzles which would also operate as a final rinse.

The second immersion stage of Figure 4 is, as described in the embodiment of Figure 4, a tank 42 containing water. For improved rinsing ability, it is envisaged that the water could be maintained at or near the boiling point such that the space above the water level in tank 42 is steam. The steam provides inerting in the space above the liquid in the zone between the two liquid seals. The presence of steam at the exit point for the conveyor assists in drying of the boards. In practice, because there would be some carry-over of solvent from the spray wash stage, there would be a mixture of water and solvent in the second immersion stage after the process has been running for some time. Thus, the vapour in the space above the liquid level could be a mixture of steam and solvent vapour.

A similar result could be achieved by dividing tank 42 into at least two portions, a first containing water near boiling point and a second containing boiling water which produces steam that fills the space above the liquid level of both portions.

A further specific example could be achieved by dividing tank 42 into two portions, a first containing boiling water which produces steam that fills the space above the liquid level of both portions and a second containing water near the boiling point.

Conventional distillation and separating techniques using condensing coils in appropriate locations could be used to recover the solvent from the steam/solvent vapour mixture to provide pure distilled hot water near the boiling point in the second immersion tank 42 for optimum cleaning results. Additional tank portions can be provided for cascading of the water whereby the circuit assemblies pass through the purest water last for optimum cleaning results.

Figure 5 shows a further proposal for a machine designed to use low flash point solvent. In this case, the machine 2″consists of a single stage, which is an immersion stage comprising a tank 12″ connected directly to an inlet channel 10″ and an outlet channel 46″. Spray nozzles 36″ are located below the surface of the solvent in tank 12″ on either side of conveyor 8. Pump 58 is shown connected to nozzles 36″.

Two liquid seals 60 are located near opposite ends of the tank 12″ to isolate the more turbulent portion of the liquid surface and an inert gas such as N$_2$ is introduced into the space between the two seals. N$_2$ could additionally be introduced into the entry and exit zones 62 and 64.

Because the spray jets are beneath the liquid surface atomization of the potentially flammable solvent is reduced.

In this embodiment, the liquid level in the tank 12″ is shown spaced below the top of the tank 12″. By adding .more solvent the tank could be completely filled such that free liquid level is located in the inlet channel 10″ and outlet channel 46″ at a point higher than the top of the tank 12″ In such a case there would be no inert gas in the tank. Moreover the liquid seals would have no effect and there would be some agitation at the free liquid level in outlet channel 10″ and outlet channel 46″.

The embodiment of Figure 4 could, with little or no modification of the apparatus, be adapted for use with a different combination of liquids. For example, tank 12 could contain flammable solvent, tank 32 water and tank 42 water. Hot water would be sprayed through the nozzles. The temperature of the water should be compatible with the process chemistry to achieve optimum cleaning results, as for example, at or near boiling point. Such an arrangement would, of course, expose the flammable solvent rather than contain it and is not, therefore, preferred.

A further modification of the basic technique involves, rather than passing the conveyor along a sinuous path, passing it instead along a straight path across the tops of various tanks, where upward waves are generated to touch the components being cleaned or to flood them.

## Claims

1. Apparatus for cleaning workpieces, comprising means for conveying the workpieces through at least one immersion wash stage comprising a tank for holding liquid cleaning solvent and a spray wash stage formed as an enclosed chamber sealed from the immersion wash stage, and having therein spray nozzles for directing sprays of liquid cleaning solvent onto the workpieces and characterized by means (40) in the enclosed chamber (32, 34, 18, 20) for introducing an inert gas into the chamber, whereby a potentially flammable or explosive liquid cleaning solvent can be used.

2. Apparatus according to claim 1 characterized by a further immersion wash stage (42) comprising a tank for holding liquid cleaning solvent and being located after the spray wash stage (32).

3. Apparatus according to claim 2, characterized in that the enclosed chamber (32, 34, 18, 20) is formed with a floor (Fig. 2) which is at least as high as sides of the tanks (12, 42) of the immersion wash stages, thereby minimizing the volume of the · enclosed chamber.

4. Apparatus according to claim 1 or 2, characterized in that the enclosed chamber (32, 34, 18, 20) has a floor formed as a shallow tray (32′) and including means for recirculating liquid from the spray nozzles (36) collected in the tray back to the nozzles.

5. Apparatus according to claim 2, characterized in that the enclosed chamber has a floor formed as a tank (32) and including means for recirculating liquid from the spray nozzles (36) collected in the tank (32) back to the nozzles.

6. Apparatus according to claim 5 characterized in that the tank (32) of the spray wash stage is not contiguous with the tanks (12, 42) of the immersion stages and including means (54, 56) for restricting carry-over of liquid from the tank (12) in the first immersion stage to the spray wash stage (32) and from the tank (32) in the spray wash stage to the second immersion stage (42) whereby different liquids can be used in each stage.

7. Apparatus according to claim 1 or 2, characterized in that means (43) are provided for extracting vapours from at least one immersion stage (12, 42).

8. Apparatus according to claim 1 to 2, characterized in that means are provided for introducing inert gas into at least one immersion stage (12, 42).

9. Apparatus according to claim 8, characterized in that the means for introducing inert gas is arranged to introduce the inert gas below the free surface of liquid in the at least one immersion stage (12, 42).

10. Apparatus according to claim 8, characterized in that the means for introducing inert gas is arranged to introduce the inert gas above the free surface of liquid in the at least one immersion stage (12, 42).

11. Apparatus according to claim 1 or 2, characterized in that means are provided for introducing into at least one immersion stage (12, 42) a blanket of a compatible liquid to float on the liquid solvent in the tank of the immersion stage.

12. Apparatus according to claim 1 or 2, characterized by detectors for detecting in at least the spray wash stage the ratio of oxygen to other gases or liquids and means for controlling the means (40) for introducing an inert gas in dependence on the detectors.

13. A method of cleaning workpieces comprising passing the workpieces through at least one immersion wash stage comprising a tank of liquid cleaning solvent and through a spray wash stage in which liquid cleaning solvent is sprayed or flooded onto the workpieces, the spray wash stage comprising a closed chamber sealed from the immersion wash stage, characterized in that the liquid cleaning solvent used in at least the spray wash stage is potentially flammable or explosive and characterized by injecting an inert gas into the spray wash stage (32) thereby to reduce oxygen in the spray wash stage and reduce the danger of fire or explosion in the spray wash stage.

14. A method according to claim 13 characterized by passing the workpieces through a further immersion wash stage (42) located after the spray wash stage (32), the liquid cleaning solvent in all of the stages being potentially flammable or explosive.

15. A method according to claim 13 characterized by passing the workpieces through a further immersion wash stage (42) located after the spray wash stage, the liquid solvent in the at least one immersion stage being a low-flammable liquid solvent compatible with the solvent for the spray wash stage (32) and the further immersion wash stage containing only water.

16. A method according to claim 13, 14 or 15, characterized by minimizing the volume of the spray wash stage.

17. A method according to claim 13, 14 or 15, characterized by extracting vapours from at least one immersion stage.

18. A method according to claim 13, 14 or 15, characterized by introducing inert gas into at least one immersion stage.

19. A method according to claim 16 characterized in that the inert gas is introduced below the free surface of liquid in the at least one immersion stage.

20. A method according to claim 16 characterized in that the inert gas is introduced above the free surface of liquid in the at least one immersion stage.

21. A method according to claim 13, 14 or 15, characterized by introducing into at least one immersion stage a compatible liquid which floats on the liquid solvent thereby to substantially fill the at least one immersion stage.

22. Apparatus for cleaning workpieces comprising means for conveying the workpieces through an immersion wash stage comprising a tank for holding liquid cleaning solvent and a spray wash stage having spray nozzles for directing sprays of liquid cleaning solvent onto the workpieces characterized in that the immersion wash stage and the spray wash stage are formed as a single combined immersion and spray wash stage comprising a tank (12″) for holding liquid cleaning solvent and spray nozzles (36″) located in the tank (12″) at a location below the normal liquid level for directing sprays of the liquid cleaning solvent onto the workpieces while they are immersed whereby a potentially flammable or explosive liquid cleaning solvent can be used.

23. Apparatus according to claim 22 characterized by means (60) for sealing at least a portion of the immersion and spray wash stage from entry (10″) and exit (46″) zones and means for introducing an inert gas into the sealed portion.

24. Apparatus according to claim 23 characterized in that the sealing means are formed of two spaced wall members (60) protruding downwards from a roof of the tank (12″) a sufficient distance to protrude beneath the free surface of liquid in the tank thereby to form liquid seals.

25. A method of cleaning workpieces comprising passing the workpieces through a tank of liquid cleaning solvent and directing sprays of the solvent from nozzles at the workpieces characterized in that the liquid cleaning solvent used is potentially flammable or explosive and characterized by directing the sprays from nozzles (36″) immersed in the tank (12″) while the workpieces are immersed thereby reducing atomization of the solvent.

26. A method according to claim 25 characterized by sealing at least a portion of the tank (12″) from entry and exit zones (10″, 46″) and introducing an inert gas into the sealed portion.

27. A method according to claim 13, 14 or 15, characterized in that the inert gas is nitrogen.

28. A method according to claim 13, 14 or 15, characterized in that the inert gas is steam.

29. Apparatus according to claim 27 in which the enclosed chamber is formed with a floor which is at least as high as sides of the tank of the immersion wash stage, thereby minimizing the volume of the enclosed chamber.

FIG. I

EP 0 387 001 A2

**FIG. 2**

**FIG. 3**

FIG. 4

FIG. 5